# EUROPEAN PATENT APPLICATION

(11) **EP 0 705 002 A2**
(43) Date of publication of application: **03.04.1996**
(21) Application number: 95306746.9
(22) Date of filing: 25.09.1995
(51) Int. Cl.: H04L 1/00

(54) **Method for cyclic redundancy code (CRC) checking in asynchronous transfer mode (ATM) packet based networks**

(30) Priority: 30.09.1994 GB 9419785
(71) Applicant: GPT LIMITED, Coventry, CV3 1HJ (GB)
(72) Inventor: Austin, Jeremy Denis Charlton, Poole, Dorset, BH15 4PD (GB)
(74) Representative: Branfield, Henry Anthony

(57) **Abstract**

In a system for transmitting a message together with a respective cyclic redundancy code (CRC) check code which is modified by the addition of a constant between a transmitter and receiver, in which the check code is the remainder after multiplying a polynomial M(x) (of order n, in which each coefficient takes the value of successive bits of the message) by x^{k}, (where k<n), and dividing by a generator polynomial G(x) of order k; a method of CRC checking comprising; dividing the received modified CRC word and message bits by the generator polynomial G(x) and checking whether the remainder is a non-zero constant.

## Description

The present invention relates to a method of cyclic redundancy code (CRC) checking in a digital transmission system which uses a modified CRC check word.

The technique of cyclic redundancy coding is well known, such as for example is described in "Error Control Coding: Fundamentals and Applications" Shu Lin and Daniel J. Costello Jr., published by Prentice-Hall Inc., and allows predictable error detection and correction in systems for transmitting digital messages. CRC checking provides a method of ensuring data integrity during transmission. To apply cyclic redundancy coding to an (n+1) bit message, the transmitter makes use of a dummy polynomial, M(x), of order n, in which each coefficient of the polynomial takes the value of successive bits of the message. The polynomial M(x) is multiplied by x^{k} and divided by a generator polynomial, G(x), of order k, where k is less than n, and each coefficient of G(x) is a constant of value 0 or 1. The division by G(x) and multiplication by x^{k} can be performed simultaneously or sequentially and in any order depending upon the hardware or software available. The remainder after these mathematical operations is a polynomial R(x), whose coefficients form the CRC check word. The CRC check word R(x), which is k bits long, is transmitted with the (n+1) bits of the message to the receiver.

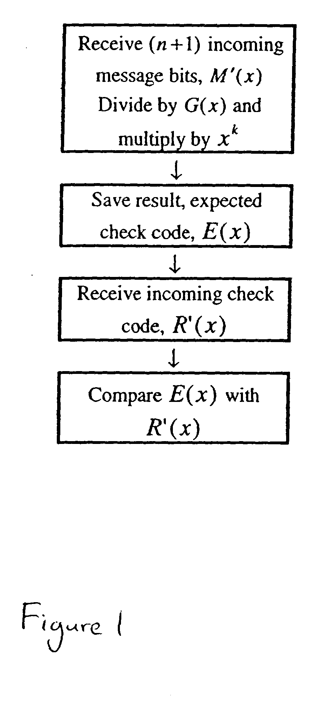

Different methods of CRC checking at the receiver have been proposed. For example, referring to Figure 1, the CRC checking system can calculate an expected CRC check word, E(x) from the (n+1) bits of the received message, M'(x), using the same algorithm applied by the transmitter. The expected CRC check word E(x), which is also k bits long, is compared with the CRC check word received, R'(x), in the expectation that a transmission error would produce a discrepancy between the two values. A disadvantage of this method is that it requires comparison of two words each k bits long.

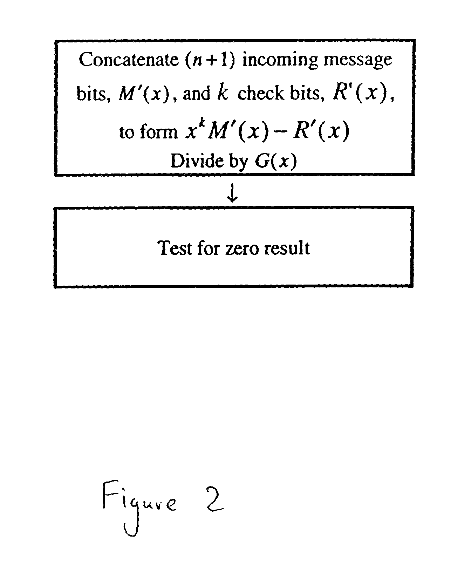

Alternatively, as shown in Figure 2, the CRC checking system at the receiver can treat the (n+1) bits of the received message and k bits of the received CRC check word R'(x) as representing the coefficient of a single polynomial of order (n+k) of the form x^{k}M'(x) - R'(x), which when divided by the generator polynomial, G(x), will produce a remainder of zero if there has been no error during transmission. If the CRC checking system calculates a non-zero result a transmission error is assumed to have occurred.

The phrase "treat the (n+1) bits of the received message as ... a single polynomial ... of the form x^{k}M'(x) - R'(x)" should not be interpreted as implying that the transmitter multiplies M(x) by x^{k}, subtracts the CRC check word R(x) and then transmits this data to the receiver. In many systems, M(x).x^{k} may well be calculated in the transmitter to get R(x) ready for transmission as soon as the (n+1) message bits have been sent, however the intermediate results produced by this are not transmitted, only M(x) is transmitted. The phrase should instead be interpreted as follows. The effect of multiplying M(x) by x^{k}, were it carried out, would be to produce a polynomial of order (n+k) in which the first (n+1) coefficients of the highest order terms correspond to the message bits and the last k coefficients are zero, that is for all terms of order less than x^{k}. As a result the (n+1) received message bits are equivalent to the first (n+1) coefficients of the polynomial x^{k}M'(x). The following k bits received, which correspond to the CRC check word R(x), can thus be treated as representing the last k coefficients of the polynomial x^{k}M'(x)+R'(x).

Since the system operates using modulo 2 arithmetic, with all carry bits being discarded, addition and subtraction are equivalent, therefore concatenating the received message bits and CRC check code can be treated as representing the coefficients of the polynomial x^{k}M'(x)-R'(x).

By employing this method the need to compare two CRC check words (k bits long) is avoided. Since the CRC check word and message bits are processed in exactly the same way, very fast bit rate serial implementations are possible.

In Asynchronous Transfer Mode (ATM) packet based networks modified CRC check words have been proposed by the International Consultative Committee for Telegraphs and Telephones (CCITT), now known as the International Telecommunications Union (ITU), to improve cell delineation performance in the case of bit slips. An additional coding term K(x), where K(x) is a fixed polynomial of order k whose coefficients are constants of value 0 or 1, is added to the CRC check word R(x). This additional coding term is provided for synchronisation purposes and does not improve or compromise the error detection performance at the receiver. In such a system the transmitter transmits a modified CRC check word of the form {R(x) + K(x)}. The receiver must subtract K(x) from the received message before applying one of the CRC checking methods described. No CRC checking systems have been proposed to fully utilise the modified CRC code.

In accordance with the present invention, there is provided a method of CRC checking comprising dividing the received modified CRC word and message bits by a generator polynomial G(x) and checking whether the remainder is a non-zero constant.

By employing the present invention fewer processing steps are involved resulting in a faster, more compact CRC checking system. For example the invention (1) eliminates temporarily storing an expected modified CRC check word E_{mfd}(X) whilst waiting to receive the received CRC check word, (R'(x)+K'(x)}, each bit of received data can therefore be processed as it is received, (2) separate processing of the received message M'(x) and received CRC check words {R'(x)+K'(x)} is not necessary, thereby reducing the hardware or software required, and (3) no processing of a variable result is required since the method tests for a non-zero constant.

The present invention will be described by way of example with reference to the accompanying drawings in which
Figures 1 and 2 are block diagrams of prior art methods of CRC checking; and
Figure 3 shows a flow chart for a method of modified CRC checking in accordance with the present invention. The CRC checking system of the present invention is intended for use in a transmission system which transmits a modified CRC word {R(x)+K(x)} in addition to an (n+1) bit message.

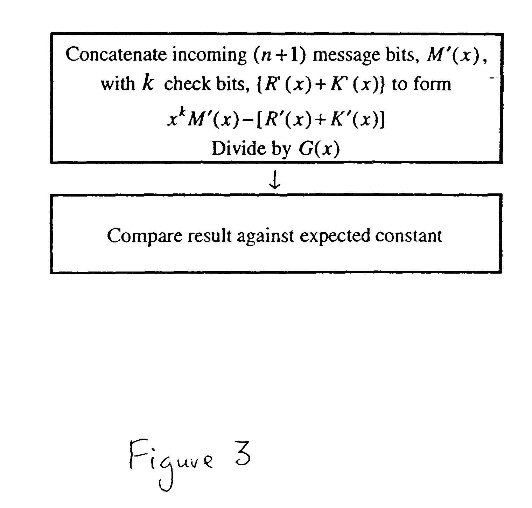

Referring to Figure 3 the receiver treats the received (n+1) message bits M'(x) and received k modified CRC check word {R'(x)+K'(x)} bits as representing the coefficients of a single polynomial of order (n+k) of the form x^{k}M'(x)-{R'(x)+K'(x)}. This polynomial is divided by the generator polynomial G(x) as each data bit representing its coefficients is received. The remainder after division of all (n+1+k) received bits will be a non-zero constant for a message that has not suffered error during transmission. Since K(x) used to modify the CRC check word is a constant the result after division by G(x) will also be a constant. As a result the need to process a variable result is eliminated. By concatenating the received message and modified CRC check word and processing each bit as it is received, separate processing of the received message and check word is no longer required. Accordingly the receiver can perform error checking faster with a corresponding reduction in the hardware or software required. There is also an improvement in the confidence of the error checking since there is a higher confidence in the design, the receive circuits being nearly identical to the transmit circuits (only the comparison combinational logic is extra).

## Claims

1. A method of cyclic redundancy code checking comprising dividing a received modified CRC word and message bits by the generator polynomial G(x) and checking whether the remainder is a non-zero constant.
